# EUROPEAN PATENT APPLICATION

(11) **EP 4 766 058 A1**
(43) Date of publication of application: **24.06.2026**
(21) Application number: 25223241.8
(22) Date of filing: 15.12.2025
(51) Int. Cl.: H05K 7/20, G06F 1/20

(54) **ULTRAPURE WATER SINGLE-PHASE IMMERSION COOLING TANK**

(30) Priority: 19.12.2024 TW 113149650
(71) Applicant: Fu, Wan-Yu, New Taipei City 244020 (TW); Wang, Hsing-Lien, New Taipei City 237007 (TW)
(72) Inventor: Fu, Wan-Yu, New Taipei City 244020 (TW); Wang, Hsing-Lien, New Taipei City 237007 (TW)
(74) Representative: Cabinet Chaillot

(57) **Abstract**

An ultrapure water single-phase immersion cooling tank includes a container (10), a liquid sensing element (11), a liquid control valve (12), an oxygen content detector (14), an exhaust valve (15), a nitrogen gas filling valve (16), an electronic pressure gauge (17), an electronic gas pressure detector (18), and a pressure analysis module (19). The container accommodates a non-conductive liquid (2) for immersing an electronic device (3). The liquid control valve conveys or discharges the non-conductive liquid. The oxygen content detector detects oxygen content in the space not immersed in the non-conductive liquid. The exhaust valve exhausts a gas mixture of oxygen and nitrogen in the space. The nitrogen gas filling valve conveys nitrogen gas into the space. The electronic pressure gauge, the electronic gas pressure detector, and the pressure analysis module obtain a precise pressure value to activate the nitrogen gas filling valve.

## Description

The present invention relates to a cooling apparatus and, more particularly, to an ultrapure water single-phase immersion cooling tank.

With changes in business models, the traditional face-to-face meeting approach has evolved into remote and online activities, creating faster and more efficient modes. Furthermore, the current mainstream electronic commerce and financial technology sectors have greatly increased their demand for various big data and cloud computing resources, leading major corporate data centers to place greater emphasis on heat dissipation issues of servers. In the past, data centers often relied on fans or ambient temperature control to cool the servers. Although this method could lower the temperature of the servers, the overall efficiency was limited, and high costs of equipment and electricity were required for cooling the servers, not only resulting in large financial expenditures but also failing to achieve the optimum heat dissipation effect. In view of the above problems, technology has been developed to cool the entire server by immersing it in the liquid. However, the servers immersed in the liquid usually contain a plurality of electronic components, and these electronic components are highly susceptible to short-circuiting caused by immersion of the liquid, which can lead to equipment malfunctions or even failure. Therefore, how to effectively control the heat dissipation and the liquid conductivity to reduce or even prevent impurities from mixing into the liquid and causing the afore-mentioned problems has become a pressing issue that relevant experts are seeking to solve.

The primary objective of the present invention is: to immerse high-temperature electronic equipment (such as servers, electronic substrates, etc.) caused by computation in a non-conductive liquid (such as ultrapure water) of a water tank, while utilizing a liquid sensing element and a liquid control valve, based on a state (including a liquid height, a liquid pH value, conductivity, or a total dissolved solids value) of the non-conductive liquid, to activate the drain port or the water inlet to refresh the non-conductive liquid inside the container, thereby maintaining the non-conductive liquid in a steady and stable state. This process keeps the high-temperature electronic equipment at a low temperature state through immersion of the non-conductive liquid. Through the immersion cooling technology, the electronic equipment achieves scalability of application, faster speed, higher computing performance, and is more efficient and structurally simpler compared to the conventional cooling devices, thus saving more costs for enterprises.

The secondary objective of the present invention is: to utilize an oxygen content detector, an exhaust valve, a nitrogen gas filling valve, an electronic pressure gauge, an electronic gas pressure detector, and a pressure analysis module, which allows the space in the container used for nitrogen filling to maintain a stable nitrogen pressure, and avoids excessive oxygen content in the nitrogen through oxygen content detection, thus stabilizing the state of the non-conductive liquid and effectively preventing chemical phenomena in the non-conductive liquid.

In accordance with the present invention, there is provided an ultrapure water single-phase immersion cooling tank comprising a container defining an accommodation space for accommodating an electronic device and a non-conductive liquid for immersing the electronic device; a drain port disposed on the container and located in the accommodation space for discharging the non-conductive liquid; a water inlet disposed on the container for injecting the non-conductive liquid; a liquid sensing element disposed on the container to detect a liquid state and a liquid level state of the non-conductive liquid; a liquid control valve connected to the liquid sensing element and configured to activate the water inlet to convey the non-conductive liquid or to activate the drain port to discharge the non-conductive liquid according to the liquid state and the liquid level state of the non-conductive liquid; an oxygen content detector installed on the container for performing oxygen content detection in a space not immersed in the non-conductive liquid and generating an oxygen content signal; an exhaust valve installed on the container, connected to the oxygen content detector, configured to exhaust a gas mixture of oxygen and nitrogen in the space according to the oxygen content signal, and synchronously connected to an electronic gas pressure detector, to discharge or replenish the gas mixture when a gas pressure of the space is too high or too low until a normal working pressure is reached; a nitrogen gas filling valve connected to the electronic gas pressure detector, and configured to convey a nitrogen gas into the space according to a gas pressure detection signal of the electronic gas pressure detector; an electronic pressure gauge disposed on the container for detecting the gas pressure of the space and displaying a first pressure value; wherein: the electronic gas pressure detector is disposed on the container for detecting the gas pressure of the space and displaying a second pressure value; the electronic gas pressure detector and the electronic pressure gauge are connected to a pressure analysis module that cross-calculates the first pressure value and the second pressure value to obtain a precise pressure value; and the pressure analysis module is connected to the nitrogen gas filling valve and the exhaust valve, and determines if the nitrogen gas filling valve and the exhaust valve are turned on or off based on the precise pressure value.

According to a preferred embodiment of the present invention, the ultrapure water single-phase immersion cooling tank further comprises a window disposed on the container, wherein the window is located at a height of the non-conductive liquid.

According to another preferred embodiment of the present invention, the liquid level state of the non-conductive liquid is divided into a low liquid level detection area for detecting a minimum liquid amount of the non-conductive liquid and a high liquid level detection area for detecting a maximum liquid amount of the non-conductive liquid, and the liquid sensing element is connected to the liquid control valve and performs conveyance or discharge of the non-conductive liquid through the water inlet or the drain port based on a detection result of the low liquid level detection area or the high liquid level detection area.

According to a further preferred embodiment of the present invention, the oxygen content detector is disposed at a height higher than a liquid surface height of the non-conductive liquid.

According to a further preferred embodiment of the present invention, the liquid state of the non-conductive liquid includes at least one of a liquid height, a liquid pH value, conductivity, or a total dissolved solids value.

According to a further preferred embodiment of the present invention, further comprising a sensor disposed on the container, for detecting a temperature state of the container.

In the drawings:
FIG. 1 is a schematic diagram of a structural configuration of a preferred embodiment of the present invention.
FIG. 2 is a schematic flowchart of an operation for detecting a non-conductive liquid according to the present invention.
FIG. 3 is a schematic flowchart of an operation for detecting nitrogen and oxygen content according to the present invention.

The implementation methods of the present invention are described below by way of specific embodiments. Those skilled in the art can easily understand other advantages and effects of the present invention from the contents disclosed in this specification.

The structures, proportions, sizes, and the like shown in the drawings accompanying this specification are only used to correspond to the content disclosed in the specification for the understanding and reading of those skilled in the art, and are not intended to limit the scope of implementation of the present invention. Therefore, they do not have substantive technical significance, and any modification of the structure, change in the proportional relationship, or adjustment of the size shall still fall within the scope covered by the technical content disclosed in the present invention, provided they do not affect the effects and achievable purposes of the present invention. At the same time, terms such as "one", "two", and "upper" used in this specification are only for the convenience of clear description and are not intended to limit the scope in which the present invention can be implemented. Changes or adjustments in their relative relationships, without substantial alteration of the technical content, should also be regarded as within the scope of the present invention.

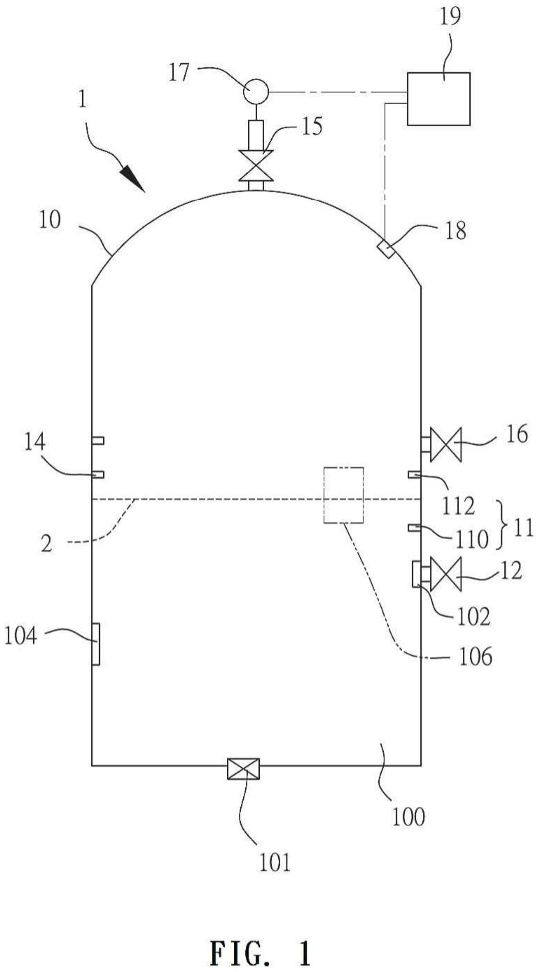

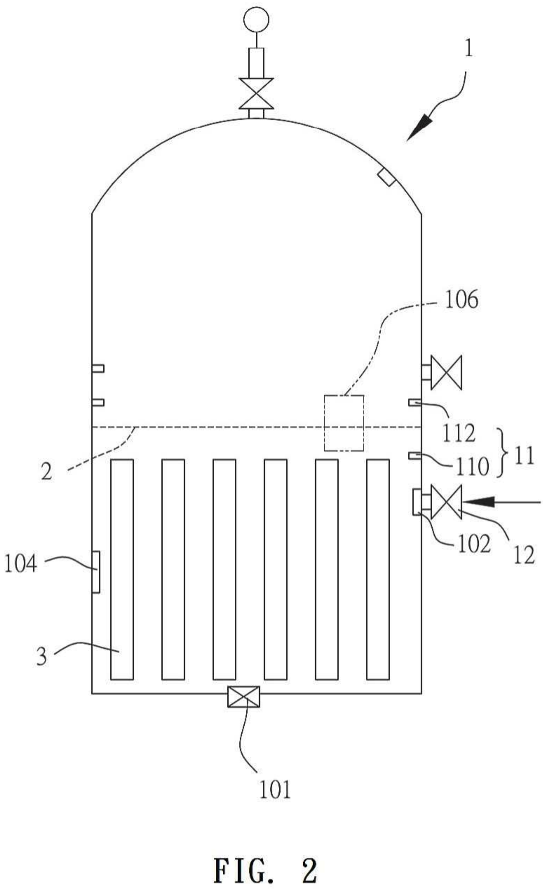

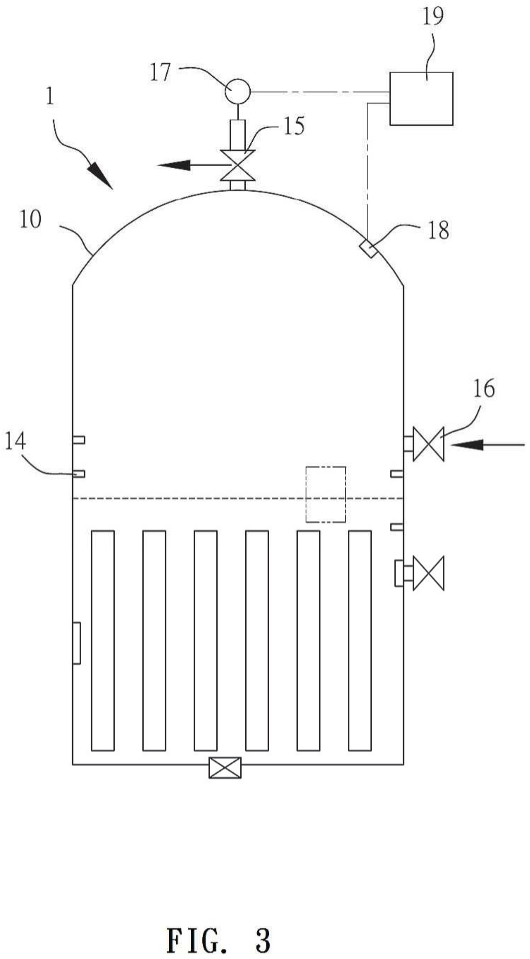

Referring to the drawings and initially to FIG. 1, FIG. 1 is a schematic diagram of a structural configuration of a preferred embodiment of the present invention. An ultrapure water single-phase immersion cooling tank 1 in accordance with the preferred embodiment of the present invention comprises a container 10, a liquid sensing element 11, a liquid control valve 12, an oxygen content detector 14, an exhaust valve 15, a nitrogen gas filling valve 16, an electronic pressure gauge 17, an electronic gas pressure detector 18, and a pressure analysis module 19. The container 10 defines an accommodation space 100, a drain port 101, and a water inlet 102. The accommodation space 100 is provided for accommodating a non-conductive liquid 2 and for immersing an electronic device 3 (referring to FIGS. 2 and 3). The liquid sensing element 11 is disposed in the container 10 to detect a liquid state and a liquid level state of the non-conductive liquid 2. The liquid control valve 12 is mainly connected to the liquid sensing element 11 and installed in the container 10. The liquid sensing element 11 activates the liquid control valve 12 to input the non-conductive liquid 2 through the water inlet 102 or discharge the non-conductive liquid 2 through the drain port 101, according to the liquid state and the liquid level state of the non-conductive liquid 2. The liquid level state of the non-conductive liquid 2 is divided into a low liquid level detection area 110 for detecting the minimum liquid amount of the non-conductive liquid 2 and a high liquid level detection area 112 for detecting the maximum liquid amount of the non-conductive liquid 2. The liquid sensing element 11 is connected to the liquid control valve 12 and performs conveying or discharging of the non-conductive liquid 2 through the water inlet 102 or the drain port 101 based on a detection result of the low liquid level detection area 110 or the high liquid level detection area 112.

A sensor 104 and a window 106 are installed on the container 10. The sensor 104 is used for detecting a temperature state of the container 10. The window 106 is located at a height of the non-conductive liquid 2. When the liquid sensing element 11 cannot operate effectively, the height of the non-conductive liquid 2 can be directly and visually observed using the window 106, and the non-conductive liquid 2 can be manually input or discharged.

In addition, the electronic gas pressure detector 18 and the oxygen content detector 14 are installed in the container 10 and are respectively used for gas pressure detection (mainly nitrogen) and oxygen content detection in a space not immersed in (or filled with) the non-conductive liquid 2, to respectively generate a gas pressure detection signal and an oxygen content signal. The exhaust valve 15 exhausts a gas mixture of oxygen and nitrogen in the space (not immersed in the non-conductive liquid 2) according to the oxygen content signal, and is synchronously connected to the electronic gas pressure detector 18, to discharge the gas mixture when a gas pressure in the space (not immersed in the non-conductive liquid 2) is too high, until a normal operating (or working) pressure is reached. The nitrogen gas filling valve 16 is connected to the electronic gas pressure detector 18 and conveys a nitrogen gas into the space (not immersed in the non-conductive liquid 2) according to the gas pressure detection signal.

Furthermore, the electronic pressure gauge 17 is disposed on the container 10 to detect the gas pressure of the space (not immersed in the non-conductive liquid 2) and display a first pressure value. The electronic gas pressure detector 18 is disposed on the container 10 to detect the gas pressure of the space (not immersed in the non-conductive liquid 2) and display a second pressure value. The electronic gas pressure detector 18 and the electronic pressure gauge 17 are connected to the pressure analysis module 19. The pressure analysis module 19 cross-calculates the first pressure value and the second pressure value to obtain a precise pressure value. The pressure analysis module 19 is connected to the nitrogen gas filling valve 16 and the exhaust valve 15 to determine whether the nitrogen gas filling valve 16 and the exhaust valve 15 are turned on or off (activated or closed) based on the precise pressure value.

Referring to FIGS. 2 and 3 with reference to FIG. 1, FIG. 2 is a schematic flowchart of an operation for detecting a non-conductive liquid according to the present invention, and FIG. 3 is a schematic flowchart of an operation for detecting nitrogen and oxygen content according to the present invention. The ultrapure water single-phase immersion cooling tank 1 of the present invention primarily achieves the effect of cooling the electronic device 3 by immersing the electronic device 3 in the non-conductive liquid 2. Compared to traditional air cooling or cooling by immersing a substrate in refrigerants or cooling oil, the ultrapure water single-phase immersion cooling tank 1 of the present invention can more effectively receive the heat generated by the electronic device 3 through the non-conductive liquid 2, thereby significantly improving heat dissipation efficiency.

The specific procedure involves placing the electronic device 3 into the accommodation space 100 of the container 10, and then injecting the non-conductive liquid 2 into the accommodation space 100 through the water inlet 102. At this time, when the liquid sensing element 11 senses or detects that a liquid level of the non-conductive liquid 2 has reached a full level, the liquid control valve 12 is used to stop the injection of the non-conductive liquid 2.

After the injection of the non-conductive liquid 2 is completed, the space (not immersed in the non-conductive liquid 2) is still full of oxygen. Therefore, the exhaust valve 15 must first be used to expel the oxygen, while the nitrogen gas is simultaneously injected into the space (not immersed in the non-conductive liquid 2) by the nitrogen gas filling valve 16. The electronic gas pressure detector 18 and the oxygen content detector 14 simultaneously monitor the gas mixture (mainly the nitrogen gas) and the oxygen content in the space (not immersed in the non-conductive liquid 2) and generate the gas pressure detection signal and the oxygen content signal, respectively.

Specifically, the low liquid level detection area 110 of the liquid level state of the liquid sensing element 11 is provided for detecting the minimum liquid amount of the non-conductive liquid 2, and the high liquid level detection area 112 of the liquid level state of the liquid sensing element 11 is provided for detecting the maximum liquid amount of the non-conductive liquid 2. The liquid control valve 12 is activated based on the liquid state (which is at least one of a liquid height, a liquid pH value, conductivity, or a total dissolved solids value) of the non-conductive liquid 2 and the liquid level state of the non-conductive liquid 2, to input the non-conductive liquid 2 through the water inlet 102 or discharge the non-conductive liquid 2 through the drain port 101.

Moreover, the installation height of the oxygen content detector 14 is approximately two centimeters (2cm) higher than the height of the high liquid level detection area 112, thereby ensuring that the oxygen content detector 14 is not submerged by the non-conductive liquid 2. If the oxygen content in the space (not immersed in the non-conductive liquid 2) is too high, it may cause a change in the liquid level state of the non-conductive liquid 2, leading to unstable signals or even damage to the electronic device 3. Therefore, when the oxygen content detector 14 detects an excessive oxygen content in the space (not immersed in the non-conductive liquid 2), the exhaust valve 15 is activated to expel the gas mixture from the space (not immersed in the non-conductive liquid 2). Since the expelled gas mixture includes not only the oxygen but also the nitrogen, the nitrogen gas filling valve 16 is simultaneously activated to fill the nitrogen gas into the space (not immersed in the non-conductive liquid 2). Concurrently, the electronic pressure gauge 17, the electronic gas pressure detector 18, and the pressure analysis module 19 are used to ensure that the nitrogen pressure in the space (not immersed in the non-conductive liquid 2) is sufficient. If the nitrogen pressure is sufficient, the input or filling of the nitrogen gas is stopped. To ensure that the nitrogen content in the space meets the set pressure standard, the gas mixture is expelled when the gas pressure of the space (not immersed in the non-conductive liquid 2) is too high until the normal operating or working pressure is reached.

As can be seen from the above description, to prevent the electronic device 3 immersed in the non-conductive liquid 2 from malfunctioning or being damaged due to the change in the liquid state (which is at least one of liquid height, liquid pH value, conductivity, or total dissolved solids value) of the non-conductive liquid 2, caused by the excessive oxygen content in the air (the gas mixture), the present invention utilizes the liquid sensing element 11 and the liquid control valve 12. The liquid sensing element 11 and the liquid control valve 12 are activated based on the liquid state and liquid level state of the non-conductive liquid 2 to convey the non-conductive liquid 2 through the drain port 101 or the water inlet 102, thereby maintaining the steady and stable state of the non-conductive liquid 2. This allows the electronic device 3, which generates high temperatures during operation, to be kept at a low temperature by being immersed in the non-conductive liquid 2. Through immersion cooling technology, the electronic device 3 achieves application scalability, faster speed, higher computing performance, and is more efficient and structurally simpler than the conventional cooling device, thereby saving more costs for enterprises.

On the other hand, through the oxygen content detector 14, the exhaust valve 15, the nitrogen gas filling valve 16, the electronic pressure gauge 17, the electronic gas pressure detector 18, and the pressure analysis module 19, the space (not immersed in the non-conductive liquid 2) in the container 10 used for filling the nitrogen can maintain a stable nitrogen pressure. By detecting the oxygen content, the excessive oxygen content in the nitrogen is avoided, which stabilizes the state of the non-conductive liquid 2 and effectively prevents damage to the electronic device 3 within the non-conductive liquid 2.

The above embodiments are merely illustrative of the principles and effects of the present invention and are not intended to limit the present invention. Any person skilled in the art may make modifications to the above embodiments without departing from the spirit and scope of the present invention. Therefore, the scope of protection for the rights of the present invention should be as set forth in the appended claims.

## Claims

1. An ultrapure water single-phase immersion cooling tank (1) comprising:
a container (10) defining an accommodation space (100) for accommodating an electronic device (3) and a non-conductive liquid (2) for immersing the electronic device;
a drain port (101) disposed on the container and located in the accommodation space for discharging the non-conductive liquid;
a water inlet (102) disposed on the container for injecting the non-conductive liquid;
a liquid sensing element (11) disposed on the container to detect a liquid state and a liquid level state of the non-conductive liquid;
a liquid control valve (12) connected to the liquid sensing element and configured to open the water inlet to convey the non-conductive liquid according to the liquid state and the liquid level state of the non-conductive liquid;
an oxygen content detector (14) installed on the container for performing oxygen content detection in a space not immersed in the non-conductive liquid and generating an oxygen content signal;
an exhaust valve (15) installed on the container, connected to the oxygen content detector, configured to exhaust a gas mixture of oxygen and nitrogen in the space according to the oxygen content signal, and synchronously connected to an electronic gas pressure detector (18), to discharge the gas mixture when a gas pressure of the space is too high until a normal working pressure is reached;
a nitrogen gas filling valve (16) connected to the electronic gas pressure detector, and configured to convey a nitrogen gas into the space according to a gas pressure detection signal of the electronic gas pressure detector;
an electronic pressure gauge (17) disposed on the container for detecting the gas pressure of the space and displaying a first pressure value;
wherein:
the electronic gas pressure detector is disposed on the container for detecting the gas pressure of the space and displaying a second pressure value;
the electronic gas pressure detector and the electronic pressure gauge are connected to a pressure analysis module that cross-calculates the first pressure value and the second pressure value to obtain a precise pressure value; and
the pressure analysis module is connected to the nitrogen gas filling valve and the exhaust valve, and determines if the nitrogen gas filling valve and the exhaust valve are turned on or off based on the precise pressure value.

2. The ultrapure water single-phase immersion cooling tank as claimed in claim 1, further comprising a window (106) disposed on the container, wherein the window is located at a height of the non-conductive liquid.

3. The ultrapure water single-phase immersion cooling tank as claimed in claim 1, wherein the liquid level state of the non-conductive liquid is divided into a low liquid level detection area (110) for detecting a minimum liquid amount of the non-conductive liquid and a high liquid level detection area (112) for detecting a maximum liquid amount of the non-conductive liquid, and the liquid sensing element is connected to the liquid control valve and performs conveyance or discharge of the non-conductive liquid through the water inlet or the drain port based on a detection result of the low liquid level detection area or the high liquid level detection area.

4. The ultrapure water single-phase immersion cooling tank as claimed in claim 1, wherein the oxygen content detector is disposed at a height higher than a liquid surface height of the non-conductive liquid.

5. The ultrapure water single-phase immersion cooling tank as claimed in claim 1, wherein the liquid state of the non-conductive liquid includes at least one of a liquid height, a liquid pH value, conductivity, or a total dissolved solids value.

6. The ultrapure water single-phase immersion cooling tank as claimed in claim 1, further comprising a sensor (104) disposed on the container, for detecting a temperature state of the container.
